# EUROPEAN PATENT APPLICATION

(11) **EP 3 550 613 A1**
(43) Date of publication of application: **09.10.2019**
(21) Application number: 17877281.0
(22) Date of filing: 30.11.2017
(51) Int. Cl.: H01L 31/0256, G02B 5/22, H01L 31/0445

(54) **ELECTRONIC DEVICE HAVING PHOTOELECTRIC CONVERSION FUNCTION**

(30) Priority: 02.12.2016 JP 2016234684
(71) Applicant: Kyoto University, Kyoto-shi, Kyoto 606-8501 (JP)
(72) Inventor: SAKAMOTO, Masanori, Kyoto-shi, Kyoto 606-8501 (JP); TERANISHI, Toshiharu, Kyoto-shi, Kyoto 606-8501 (JP); KAWAWAKI, Tokuhisa, Kyoto-shi, Kyoto 606-8501 (JP)
(74) Representative: Müller-Boré & Partner Patentanwälte PartG mbB
(86) International application number: PCT/JP2017/043191
(87) International publication number: WO 2018/101446

(57) **Abstract**

Provided is an electronic device that is capable of converting infrared light and ultraviolet light into electrical energy and that exhibits high transparency. The electronic device includes a layer containing a transparent plasmonic material.

## Description

### Technical Field

The present invention relates to electronic devices having a photoelectric conversion function.

### Background Art

From the standpoint of designability and efficiency of power generation, attempts have been made to manufacture transparent solar cells.

Although some research papers report organic thin-film solar cells as such a transparent solar cell (NPL 1 and 2), these solar cells are noticeably colored, and transparency remains to be addressed. Additionally, such organic thin-film cells have an issue in light stability due to their use of an organic substance as a light-absorbing material.

Methods for eliminating color by using a photon concentrator have also been suggested. However, the color does not appear to be effectively eliminated.

Infrared light accounts for about 44% of the solar light spectrum. Although various methods for converting infrared light into energy have been studied in an attempt to effectively use this light, an efficient method remains to be established at present.

Heat rising in a closed space, such as in a car or a train, is caused by irradiation of infrared rays. Efficiently cutting infrared rays can save energy consumed for air conditioning. Many of the materials that have absorption in the near-infrared region have a strong color derived from absorption in the visible region. Thus, except for some organic molecules and organic salts, few materials achieve both transparency and absorption in the infrared region. However, an electronic device capable of absorbing light in the infrared region and converting it into electrical energy while having high transparency would be extremely beneficial from the viewpoint of designability and economic performance.

Invisible rays aside from infrared rays include ultraviolet rays. Ultraviolet rays, however, cause adverse effects on the human body. It would be beneficial for the health of humans if ultraviolet rays coming into a human living space are absorbed and converted into electrical energy.

Thus, there has been demand for electronic devices that have high transparency and that are capable of converting infrared light and/or ultraviolet light into electrical energy.

### Citation List

### Non-patent Literature

NPL 1: R. R. Lunt and V. Bulovic, Appl. Phys. Lett., 2011, 98, 113305.
NPL 2: P. S. Weiss and Y. Yang et al., ACS Nano, 2012, 6, 7185-7190.

### Summary of Invention

### Technical Problem

In view of the circumstances described above, an object of the present invention is to provide an electronic device that is capable of converting infrared light and/or ultraviolet light into electrical energy and that exhibits high transparency.

### Solution to Problem

The present inventors conducted extensive research to achieve the object, and found that providing a transparent plasmonic material layer formed from a transparent plasmonic material enables an electronic device that exhibits high transparency and that is capable of converting infrared light and/or ultraviolet light into electrical energy. The inventors thus completed the invention.

Specifically, the present invention relates to the following subject matter.
1. An electronic device comprising a layer containing a transparent plasmonic material.
2. The electronic device according to item 1, wherein the transparent plasmonic material has a transmittance of 60% or more at a wavelength of 550 nm.
3. The electronic device according to item 1 or 2, wherein the transparent plasmonic material is transparent plasmonic nanoparticles.
4. The electronic device according to item 3, wherein the transparent plasmonic nanoparticles contain at least one member selected from the group consisting of transparent conductive oxides, copper sulfide, copper phosphide, copper telluride, copper selenide, ruthenium oxide, rhenium oxide, molybdenum oxide, tungsten oxide, tungsten bronze, and delafossite copper oxide, all of which have LSPR absorption in the infrared region.
5. The electronic device according to item 3, wherein the transparent plasmonic nanoparticles are tin-doped indium oxide nanoparticles.
6. The electronic device according to any one of items 3 to 5, wherein the transparent plasmonic nanoparticles have a mean particle size of 2 to 1000 nm.
7. The electronic device according to any one of items 1 to 6, further comprising electrodes.
8. The electronic device according to any one of items 1 to 7, further comprising a carrier transport layer.
9. The electronic device according to any one of items 1 to 8, which is a photoelectric conversion device.
10. A method for obtaining electric power,
   the method comprising allowing a transparent plasmonic material to absorb at least one member selected from the group consisting of infrared light, ultraviolet light, and visible light having a wavelength of 440 nm or less.
11. The method according to item 10, wherein the transparent plasmonic material is transparent plasmonic nanoparticles.
12. The method according to item 11, wherein the transparent plasmonic nanoparticles are a transparent conductive oxide having LSPR absorption in the infrared region.

### Advantageous Effects of Invention

The electronic device according to the present invention described above can convert infrared light and/or ultraviolet light into electric energy, and exhibits high transparency.

### Brief Description of Drawings

Fig. 1 is a diagram that illustrates a photocurrent measurement method in Example 1.
Fig. 2 illustrates the results of photocurrent measurement performed when light was transmitted through a bandpass filter in Example 1.
Fig. 3 illustrates the results of a transmission spectrum in Example 1.
Fig. 4 is a diagram that illustrates a photocurrent measurement method in Example 2.
Fig. 5 illustrates the results of photocurrent measurement performed without a filter in Example 2.
Fig. 6 illustrates the results of photocurrent measurement performed when light was transmitted through a longpass filter in Example 2.

### Description of Embodiments

The electronic device according to the present invention includes a layer containing a transparent plasmonic material.

Examples of electronic devices include photoelectric conversion devices, such as photoconductive devices, photodiodes, optical isolators, optical integrated circuits, phototransistors, photoelectric cells, photoelectric tubes, photomultipliers, light-emitting diodes, semiconductor lasers, photodetectors, photochemical sensors, solar cells, and photocatalysts. Examples further include devices that exhibit various functions using electrical energy obtained due to photoelectric effects, such as televisions, audio devices, wearable devices, and information devices.

The transparent plasmonic material is a plasmonic material with transparency. The definition of transparency in the present specification is not particularly limited, as long as the material is visually recognizable as transparent. Specifically, the transparent plasmonic material has a transmittance of preferably 60% or more, and more preferably 80% or more at a wavelength of 550 nm. The upper limit of the transmittance at a wavelength of 550 nm is not particularly limited. Typically, the upper limit is preferably 100%, more preferably 99%, and still more preferably 95%.

Plasmonic materials are capable of causing localized surface plasmon resonance ("LSPR"). The transparent plasmonic material is not particularly limited as long as the material has transparency as described above and can cause LSPR. A wide range of known materials satisfying these conditions can be used. Whether LSPR has occurred can be confirmed by a method to clarify that the change in absorption-peak wavelength is linear when the refractive index in the surrounding region is changed.

Because the electronic device includes a layer containing such a transparent plasmonic material, electric power can be obtained through photoelectric conversion by allowing the layer containing the transparent material to absorb low-visible long-wavelength light. Likewise, it is also possible to obtain electric power by allowing the layer containing a transparent plasmonic material to absorb low-visible, short- wavelength light. In the present specification, infrared light refers to light with a wavelength longer than 680 nm.

The transparent plasmonic material for use is preferably transparent plasmonic nanoparticles. This is because the excellent photoelectric conversion ability can be drawn from the transparent plasmonic material.

Transparent plasmonic nanoparticles for use preferably have a mean particle size of 2 to 1000 nm, more preferably 2 to 500 nm, and still more preferably 2 to 100 nm. Transparent plasmonic nanoparticles having a particle size within such numerical ranges enable the transparency and the energy conversion efficiency to further improve. The mean particle size of the nanoparticles can be measured by observation with a microscope, such as an electron microscope, an atomic force microscope, or a tunnel microscope, or by a dynamic or static light-scattering method.

The layer containing a transparent plasmonic material is not particularly limited, as long as the layer contains at least the transparent plasmonic material. Specifically, the layer can be obtained by subjecting transparent plasmonic nanoparticles to, for example, sputtering, vapor deposition, spin coating, dip coating, inkjet printing, or screen printing. The protective ligand for use in the process such as spin coating, dip coating, inkjet printing, or screen printing may be any of the following: a cationic surfactant, an anionic surfactant, a nonionic surfactant, and a short ligand (cations, anions, and metal chalcogenides). More specifically, protective ligands for use include a quaternary ammonium salt surfactant, such as CTAB as a cationic surfactant; sodium alkyl carboxylate, sodium alkyl benzene sulfonate, sodium alkyl sulfonate, and sodium alkyl phosphate as an anionic surfactant; glyceryl monostearate, and octaethylene glycol monododecyl ether as a nonionic surfactant; and mercaptopropionic acid, lipoic acid, S²⁻ anions, I⁻ anions, Br⁻ anions, Cl⁻ anions, NO³⁻ anions, Sn₂S₆⁴⁻ anions, SbInSe²⁻ anions, CdCl₃⁻ anions, MoS₄²⁻ anions, Se²⁻ anions, HSe⁻ anions, Te²⁻ anions, HTe⁻ anions, TeS₃²⁻ anions, OH⁻ anions, NH²⁻ anions, and polyacid as a short ligand. However, of course, the protective ligand is not limited to these ligands. Of these, short ligands are preferable from the standpoint of excellent conductivity. When a surfactant or ligand listed above is used, the following operation may be necessary: removing the ligand or surfactant by sintering, and recovering LSPR by tempering under reducing conditions to bond the transparent plasmonic nanoparticles to the transparent conductive material layer.

The content of transparent plasmonic material in the layer containing a transparent plasmonic material is preferably 80 to 100% by mass, and more preferably 90 to 100% by mass. A content of transparent plasmonic material within such numerical ranges provides higher conductivity. The content of the surfactant and the ligand in the layer containing a transparent plasmonic material is preferably 20% by mass or less in the layer containing transparent plasmonic material that is taken as 100% by mass. A content of the surfactant and the ligand within such a numerical range provides high conductivity.

The transparent plasmonic material for use is not particularly limited. Examples include nanoparticles containing at least one member selected from the group consisting of transparent conductive oxides, copper sulfide, copper phosphide, copper telluride, copper selenide, ruthenium oxide, rhenium oxide, molybdenum oxide, tungsten oxide, tungsten bronze, and delafossite copper oxide, all of which have LSPR absorption in the infrared region, specifically a long-wave region from a wavelength of 750 to 2500 nm.

The transparent conductive oxide having LSPR absorption in the infrared region is not particularly limited. Specific examples include tin-doped indium oxide, aluminum-doped indium oxide, cerium-doped indium oxide, aluminum-doped zinc oxide, gallium-doped zinc oxide, indium-doped zinc oxide, indium-doped cadmium oxide, fluorine-indium-doped cadmium oxide, fluorine-doped cadmium oxide, chlorine-doped cadmium oxide, bromine-doped cadmium oxide, cesium-doped molybdenum oxide, antimony-doped tin oxide, fluorine-doped tin oxide, and titanium oxide. These oxides can be used singly or in a combination of two or more.

The copper sulfide for use is also not particularly limited, and a wide range of copper sulfide known as a transparent plasmonic material can be used. Specific examples include CuS, and Cu₂₋ₓS wherein 0<x<1. These can be used singly or in a combination of two or more.

The copper phosphide for use is also not particularly limited, and a wide range of copper phosphide known as a transparent plasmonic material can be used. Specific examples include Cu₃₋ₓP wherein 0<x<1, and CuP. These can be used singly or in a combination of two or more.

The copper telluride for use is also not particularly limited, and a wide range of copper telluride known as a transparent plasmonic material can be used. Specific examples include CuTe, and Cu₂₋ₓTe wherein 0<x<1. These can be used singly or in a combination of two or more.

The copper selenide for use is also not particularly limited, and a wide range of copper selenide known as a transparent plasmonic material can be used. Specific examples include CuSe, and Cu₂₋ₓSe wherein 0<x<1. These can be used singly or in a combination of two or more.

The ruthenium oxide for use is also not particularly limited, and a wide range of ruthenium oxide known as a transparent plasmonic material can be used. Specific examples include RuO₂, and RuO₂₋ₓ wherein 0<x<1. These can be used singly or in a combination of two or more.

The rhenium oxide for use is also not particularly limited, and a wide range of rhenium oxide known as a transparent plasmonic material can be used. Specific examples include ReO₂, and ReO₂₋ₓ wherein 0<x<1. These can be used singly or in a combination of two or more.

The molybdenum oxide for use is also not particularly limited, and a wide range of molybdenum oxide known as a transparent plasmonic material can be used. Specific examples include MoO₃, and MoO₃₋ₓ wherein 0<x<1. These can be used singly or in a combination of two or more.

The tungsten oxide for use is also not particularly limited, and a wide range of tungsten oxide known as a transparent plasmonic material can be used. Specific examples include WO₃, and WO₃₋ₓ wherein 0<x<1. These can be used singly or in a combination of two or more.

The tungsten bronze for use is also not particularly limited, and a wide range of tungsten bronze known as a transparent plasmonic material can be used. Specific examples include alkali metal-doped WO₃, such as CsₓWO₃ wherein 0<x<1, LiWO₃, LiCsWO₃, LiRbWO₃, and LiKWO₃. These can be used singly or in a combination of two or more.

The delafossite copper oxide for use is also not particularly limited, and a wide range of delafossite copper oxide known as a transparent plasmonic material can be used. Specific examples include CuAlO₂, CuGaO₂, and CuCrO₂. These can be used singly or in a combination of two or more.

The layer containing a transparent plasmonic material preferably has a thickness of 1 to 100 µm, and more preferably 1 to 1000 nm. A layer containing a transparent plasmonic material having a thickness within such numerical ranges can exhibit higher transparency and have an advantage in carrier transport.

The layer containing a transparent plasmonic material configured as described above is preferably provided with electrodes, because this enables efficient recovery of electric power. The electrodes for use are not particularly limited, and a wide range of known materials typically used in electronic devices can be used. Of such materials, those having high transparency, such as ITO, FTO, gold, silver, aluminum, carbon, graphene, and carbon nanotubes, are preferable from the standpoint of securing the transparency of electronic devices.

It is also a preferred embodiment to provide a carrier transport layer for transporting carriers such as electrons between the layer containing a transparent plasmonic material and an electrode. There is no particular limitation on the material for forming such a carrier transport layer. Specific examples include delafossite copper oxides, such as TiO₂, ZnO, SnO₂, CdO, and CuAlO₂; and polymeric materials, such as spiro-MeOTAD (2,2',7,7'-tetrakis[n,n-di-p-methoxyphenylamino]-9,9'-spirobifluorene), PEDOT:PSS (poly(3,4-ethylenedioxythiophene)-poly(styrenesulfonate)), PCBM (phenyl C60 butyric acid methyl ester), P3HT (poly(3-hexylthiophene)), PPV (polyphenylenevinylenes), and polyfluorenes. Providing a carrier transport layer enables more efficient recovery of electric power. The carrier transport layer preferably has transparency from the standpoint of securing the transparency of the resulting electronic device. As with the transparent plasmonic material, the carrier transport layer preferably has a transmittance of 60% or more, and more preferably 80% or more at a wavelength of 550 nm. The upper limit of the transmittance at a wavelength of 550 nm is also preferably 100%, more preferably 99%, and still more preferably 95%.

The method for forming a carrier transport layer is not particularly limited. For example, the material for constituting the carrier transport layer described above may be dissolved in a solvent, such as toluene, chloroform, hexane, water, N,N-dimethylformamide, alcohol, or N-methylformamide, and the obtained solution is used in an appropriate method such as coating or spraying.

Although a carrier transport layer formed as a single layer can provide the effect, it is preferable to form a carrier transport layer in two or more layers. The carrier transport layer preferably has a thickness of 1 to 1000 nm as a whole. A carrier transport layer having a thickness within such a numerical range can further improve conductivity.

Although embodiments of the present invention are described above, the present invention is not limited to these embodiments. It is needless to say that the present invention can be practiced in various forms without departing from the spirit and principal concept of the invention.

### Examples

The following describes embodiments of the present invention in more detail with reference to Examples. However, the present invention is not limited to these Examples.

### Example 1

A film of TiO₂ was formed as a carrier transport layer on one side of tin-doped indium oxide glass (length: 2 cm, width: 2 cm, and thickness: 1 cm) as an electrode that was prepared to give a thickness of 150 nm by sputtering. Cu₂₋ₓS was further applied thereon to form a film as a layer containing a transparent plasmonic material such that the carrier transport layer had a thickness of 100 nm, and that the layer containing a transparent plasmonic material had a thickness of 150 nm. The TiO₂ layer was obtained by spraying the tin-doped indium oxide glass heated to 500°C on a hot plate with a solution of titanium tetraisopropoxide in isopropanol by spray pyrolysis, and sintering the result for 30 minutes. A solution containing Cu₂₋ₓS nanoparticles was prepared by heating a mixture solution of copper(I) chloride, sulfur powder, oleic acid, and oleylamine at 140°C for 5 minutes in a nitrogen atmosphere. Ethanol and hexane were further added to the solution containing Cu₂₋ₓS nanoparticles, and the solution was purified by centrifugation, followed by dissolving the resulting precipitate in hexane, thereby obtaining a dispersion of Cu₂₋ₓS nanoparticles. The dispersion of Cu₂₋ₓS nanoparticles (a solution of transparent plasmonic nanoparticles), a solution of hexadecyltrimethylammonium bromide in methanol (a solution for replacement of a protecting agent), and methanol (a washing solution for removing excess nanoparticles and protecting agent) were individually dropped onto the tin-doped indium oxide glass, and spin coating was sequentially performed. This operation was repeated 20 times to form a Cu₂₋ₓS layer. A gold electrode was further added thereon by vapor deposition, thereby obtaining a solar cell.

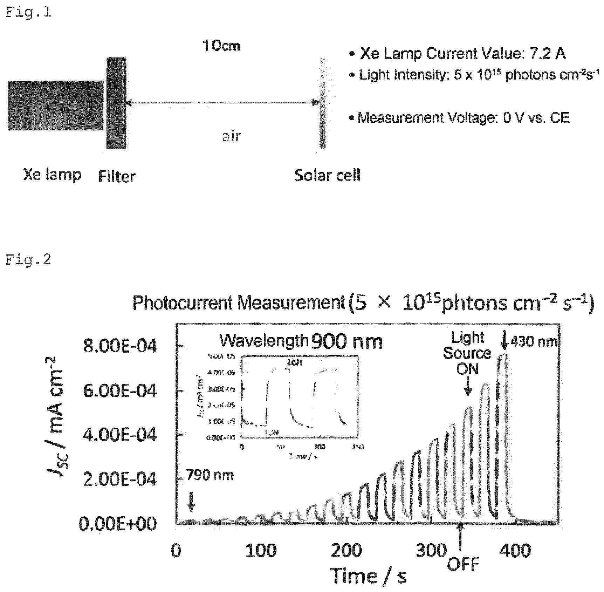

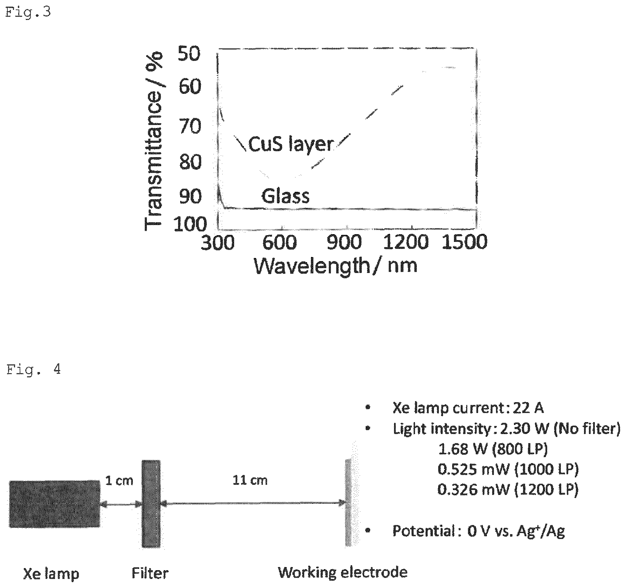

As illustrated in Fig. 1, a bandpass filter (half width: 10 nm) was disposed to face a xenon lamp, which was a light source (produced by Asahi Spectra Co., Ltd.; model number: LAX-102). The solar cell of Example 1 was then placed at a position 10 cm away from the bandpass filter so as to face the light source. The xenon lamp was energized at a current of 7.2 A. The number of photons that were transmitted through the bandpass filter was 5 × 10¹⁵ photons cm⁻² s⁻¹. When the solar cell was sequentially irradiated with light within a wavelength from 790 nm at the long wavelength side to up to 430 nm at the short wavelength side at intervals of 20 nm every 30 seconds under the conditions above, a current due to irradiation was observed in all of the wavelength regions (Fig. 2). When the solar cell was irradiated with near-infrared light with a wavelength of 900 nm, a photocurrent was also observed (the inset in Fig. 2). This reveals that the prepared device also functions as a solar cell when low-visible, short-wave light (430 nm) or near infrared light (900 nm) is used. The solar cell also exhibited high transmittivity, with a light transmittance of 85% at a wavelength of 550 nm at that time (Fig. 3).

### Example 2

A 100-nm-thick SnO₂ layer was formed by sputtering on a titanium plate (length: 1 cm, width: 5 cm, and thickness: 5 mm) that served as an electrode, and a solution of tin-doped indium oxide nanoparticles with a mean particle size of 12 nm (25.6 mg) in chloroform (50 µl) was applied thereon by spin coating (spin coating conditions: 100 rpm, 15s -> 1000 rpm, 30s). The obtained electrode was sintered at 600°C for 30 minutes in the atmosphere to bond the tin-doped indium oxide nanoparticles to the SnO₂ layer. Thereafter, the tin-doped indium oxide nanoparticles were reduced by heating in 4% H₂/Ar at 280°C for 5 hours to recover the absorption of LSPR.

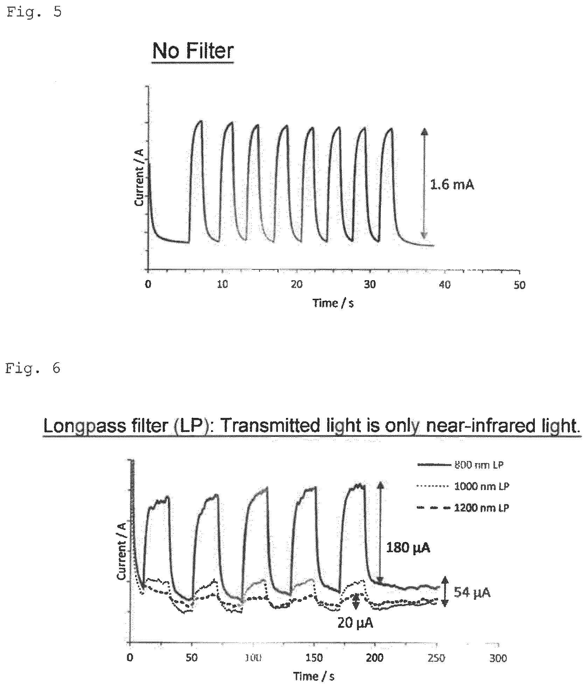

The electrodes were set in the alignment as illustrated in Fig. 4, and a longpass filter was disposed at a position 1 cm away from a xenon lamp as a light source (produced by Eagle Engineering, model number: R-300-3J) so as to face the light source. The solar cell obtained above was placed at a position 11 cm away from the longpass filter so as to face the light source, and the current value under light irradiation was measured. The intensity of the light emitted from the xenon lamp was 2.3 W without a filter. When light was transmitted through the longpass filter at a position of 11 cm from the light source, the light intensity was 1.68 W, 0.525 W, and 0.326 W, respectively, with the longpass filters of 800 nm, 1000 nm, and 1200 nm. When the prepared device was irradiated with light from the xenon lamp without a longpass filter and with longpass filters of 800 nm, 1000 nm, and 1200 nm, a current due to the irradiation was observed (Figs. 5 and 6). This reveals that photoelectric conversion can be performed using ITO nanoparticles, which are a transparent conductive material. This also reveals that the device functions as a solar cell when invisible near infrared light (800 nm or more) is used. Additionally, the light transmittance of the solar cell at that time was 90% at a wavelength of 550 nm. This confirms that the solar cell exhibits high transmittivity.

## Claims

1. An electronic device comprising a layer containing a transparent plasmonic material.

2. The electronic device according to claim 1, wherein the transparent plasmonic material has a transmittance of 60% or more at a wavelength of 550 nm.

3. The electronic device according to claim 1 or 2, wherein the transparent plasmonic material is transparent plasmonic nanoparticles.

4. The electronic device according to claim 3, wherein the transparent plasmonic nanoparticles contain at least one member selected from the group consisting of transparent conductive oxides, copper sulfide, copper phosphide, copper telluride, copper selenide, ruthenium oxide, rhenium oxide, molybdenum oxide, tungsten oxide, tungsten bronze, and delafossite copper oxide, all of which have LSPR absorption in the infrared region.

5. The electronic device according to claim 3, wherein the transparent plasmonic nanoparticles are tin-doped indium oxide nanoparticles.

6. The electronic device according to any one of claims 3 to 5, wherein the transparent plasmonic nanoparticles have a mean particle size of 2 to 1000 nm.

7. The electronic device according to any one of claims 1 to 6, further comprising electrodes.

8. The electronic device according to any one of claims 1 to 7, further comprising a carrier transport layer.

9. The electronic device according to any one of claims 1 to 8, which is a photoelectric conversion device.

10. A method for obtaining electric power,
the method comprising allowing a transparent plasmonic material to absorb at least one member selected from the group consisting of infrared light, ultraviolet light, and visible light having a wavelength of 440 nm or less.

11. The method according to claim 10, wherein the transparent plasmonic material is transparent plasmonic nanoparticles.

12. The method according to claim 11, wherein the transparent plasmonic nanoparticles are a transparent conductive oxide having LSPR absorption in the infrared region.
